# DEMANDE DE BREVET EUROPEEN

(11) **EP 4 601 450 A1**
(43) Date de publication de la demande: **13.08.2025**
(21) Numéro de dépôt: 24223744.4
(22) Date de dépôt: 30.12.2024
(51) Int. Cl.: H10N 10/17, G01K 7/02, H10N 10/01

(54) **AMÉLIORATIONS RELATIVES À UN CAPTEUR FLEXIBLE ET À UNE MÉTHODE DE PRODUCTION ASSOCIÉE**

(30) Priorité: 06.02.2024 FR 2401152
(71) Demandeur: Scienteama, 14200 Hérouville-Saint-Clair (FR)
(72) Inventeur: AGNUS, Benoît, 14610 Villons-les-Buissons (FR)
(74) Mandataire: HGF

(57) **Abrégé**

L'invention concerne un dispositif en tissu souple destiné à être utilisé dans des applications thermiques, comprenant un tissu souple (100) constitué d'une combinaison d'un premier ensemble de jonctions (400) et d'un deuxième ensemble de jonctions formés chacun à partir d'un premier et d'un deuxième matériaux respectifs, chacun ayant un premier coefficient thermoélectrique et un deuxième coefficient thermoélectrique connus, le premier ensemble de jonctions (400) étant séparé du deuxième ensemble de jonctions par un troisième matériau et l'un des éléments suivants étant généré sur la base des premier et deuxième coefficients thermoélectriques :
- une réponse électrique entre le premier ensemble de jonctions (400) et le deuxième ensemble de jonctions en fonction d'un gradient de température différent entre eux ; et
- une réponse thermique entre le premier ensemble de jonctions (400) et le deuxième ensemble de jonctions basée sur une différence de gradient électrique entre eux.

## Description

### Domaine technique de l'invention

La présente invention concerne un capteur flexible et un procédé de fabrication associé, en particulier, mais pas exclusivement, un capteur d'énergie à gradient thermique formé à partir d'un tissu ou d'un textile.

### Arrière-plan technique

Les capteurs sont utilisés dans une grande variété de situations et se présentent sous de nombreux types ou formes différents. Un domaine particulier de développement des capteurs existe sous la forme de capteurs en tissu ou en textile fabriqués à partir de ce que l'on appelle des fils techniques. Un fil technique est un fil, un câble, une fibre ou un brin de matériau qui, lorsqu'il est inclus dans un tissu ou un textile, produit une fonctionnalité technique supérieure à celle envisagée par la simple formation d'un tissu ou d'un textile. Par exemple, un fil peut comprendre différents types de matériaux, tels qu'un métal ou un isolant, tissés ou cousus ensemble pour former un article en tissu qui peut également servir de capteur. Les matériaux textiles fabriqués à partir de fils ayant la capacité de générer et de transmettre de l'énergie électrique sont bien connus. Un certain nombre de techniques différentes ont été jugées utiles pour mettre en oeuvre cette technologie.

L'un des domaines dans lesquels les capteurs en tissu pourraient être intéressants est la mesure du gradient thermique d'un article. L'utilisation d'un capteur en tissu est particulièrement intéressante car il est flexible et peut être facilement conformé ou moulé à la surface d'un article où une mesure par un capteur peut être nécessaire. Par conséquent, le capteur est en relation très étroite avec l'article et les mesures peuvent être très précises.

Il existe un besoin pour un meilleur capteur fabriqué à partir d'un tissu qui soit durable, flexible et fiable. La présente invention vise donc à améliorer la réalisation et la mise en oeuvre de matériaux textiles conducteurs d'électricité comprenant un capteur associé.

### Résumé de l'invention

La présente invention selon au moins un de ses modes de réalisation concerne un dispositif en tissu souple destiné à être utilisé dans des applications thermiques, caractérisé en ce qu'il comprend un tissu souple constitué d'une combinaison d'un premier ensemble de jonctions et d'un deuxième ensemble de jonctions formés chacun à partir d'un premier et d'un deuxième matériaux respectifs, chacun ayant un premier coefficient thermoélectrique et un deuxième coefficient thermoélectrique connus, le premier ensemble de jonctions étant séparé du deuxième ensemble de jonctions par un troisième matériau et l'un des éléments suivants étant généré sur la base des premier et deuxième coefficients thermoélectriques :
- une réponse électrique entre le premier ensemble de jonctions et le deuxième ensemble de jonctions en fonction d'un gradient de température différent entre eux ; et
- une réponse thermique entre le premier ensemble de jonctions et le deuxième ensemble de jonctions basée sur une différence de gradient électrique entre eux.

Selon au moins un mode de réalisation de l'invention, le premier coefficient thermoélectrique est le coefficient de Seebeck.

Selon au moins un mode de réalisation de l'invention, le dispositif en tissu souple est un capteur pour déterminer un gradient thermique (d) dans un environnement prédéterminé.

Selon au moins un mode de réalisation de l'invention, le premier coefficient thermoélectrique est le coefficient de Peltier.

Selon au moins un mode de réalisation de l'invention, le dispositif en tissu souple est un élément de chauffage ou de refroidissement d'un environnement.

Selon au moins un mode de réalisation de l'invention, le premier ensemble de jonctions est formé dans une première couche et le deuxième ensemble de jonctions est formé dans une deuxième couche et la première et la deuxième couche sont séparées l'une de l'autre par une couche du troisième matériau.

Selon au moins un mode de réalisation de l'invention, le premier ensemble de jonctions et le deuxième ensemble de jonctions sont respectivement des jonctions chaudes et froides.

Selon au moins un mode de réalisation de l'invention, le premier ensemble de jonctions et le deuxième ensemble de jonctions sont formés en cousant des fibres des matériaux respectifs ensemble pour former des points ou des noeuds.

Selon au moins un mode de réalisation de l'invention, la densité du premier ensemble de jonctions et du deuxième ensemble de jonctions est associée à une précision de fonctionnement du dispositif en cours d'utilisation.

Selon au moins un mode de réalisation de l'invention, le premier matériau est choisi dans le groupe comprenant : carbone, aluminium, scandium, tungstène, nickel ;
et le second matériau est choisi dans le groupe comprenant : argent, or, fer, cadmium, cuivre, zirconium, sélénium, chrome, lithium.

Selon au moins un mode de réalisation de l'invention, le troisième matériau est choisi dans le groupe comprenant les polymères, les polymères chargés, les polymères dopés, les copolymères dont la dureté ou l'élasticité peut être modulée, les résines, éthylène-acétate de vinyle (EVA), polystyrène (PS), polyéthylène (PE), polypropylène (PP), polycarbonate (PC), acrylonitrile butadiène styrène (ABS), polychlorure de vinyle (PVC), polyméthacrylate de méthyle (PMMA), polystyrène choc (SB),et Nylon.

L'invention selon au moins un de ses modes de réalisation concerne également un procédé de formation d'un dispositif en tissu souple à partir d'un tissu souple caractérisé en ce qu'il comprend les étapes suivantes :
la formation de premières jonctions dans une couche d'un premier matériau ayant un premier coefficient thermoélectrique ;
la formation des secondes jonctions dans la couche d'un second matériau ayant un second coefficient thermoélectrique ;
la fusion des couches à l'aide d'un matériau thermoactif ; et
l'exposition des jonctions dans les couches pour permettre aux premier et second matériaux de réagir à la chaleur, dans lequel le tissu flexible formé est configuré pour l'un des éléments suivants :
   la génération d'une réponse électrique entre les premières jonctions et les secondes jonctions sur la base d'une différence de gradient de température entre elles ; et
   la génération d'une réponse thermique entre les premières jonctions et les secondes jonctions sur la base d'une différence de gradient électrique entre elles.

Selon au moins un mode de réalisation de l'invention, les premières et secondes jonctions sont formées en cousant un fil ayant une configuration prédéterminée de premières et secondes jonctions dans le tissu flexible.

Selon au moins un mode de réalisation de l'invention, le premier et le deuxième matériaux comprennent un revêtement amovible.

Selon au moins un mode de réalisation de l'invention, le revêtement est soluble dans l'eau et la méthode comprend en outre l'élimination du matériau soluble dans l'eau à l'aide d'un bain d'eau dans lequel le matériau soluble dans l'eau peut se dissoudre.

Selon au moins un mode de réalisation de l'invention, le procédé comprend en outre une étape d'exposition des jonctions dans les couches pour permettre au premier et au second matériau d'être sensibles à la chaleur, et une étape de découpage du revêtement amovible du premier et du second matériau.

### Brève description des figures

D'autres caractéristiques et avantages de l'invention apparaitront au cours de la lecture de la description détaillée qui va suivre pour la compréhension de laquelle on se reportera aux dessins annexés dans lesquels :
La figure 1 est un schéma simplifié d'un capteur, selon un aspect de l'invention.
La figure 2 est une coupe transversale du schéma de la figure 1 ;
La figure 3 est un schéma plus détaillé du capteur de la figure 1, selon un aspect de l'invention ;
La figure 4 est un exemple de la manière dont les fils d'un tissu sont cousus ou noués ensemble selon la présente invention ;
La figure 5 et la figure 6 montrent comment le tissu peut être cousu à l'aide d'une machine à coudre ou autre, selon un aspect de l'invention ;
La figure 7 est une vue plus détaillée du capteur qui montre comment le tissu peut être utilisé comme capteur, conformément à un aspect de l'invention.

### Description détaillée de l'invention

La présente invention concerne un capteur en tissu capable de mesurer un gradient thermique ou un autre type de profil de température, du fait que le capteur est placé contre ou à proximité d'un article pour lequel une mesure est requise. Le tissu est constitué d'une combinaison de fils ayant chacun une caractéristique électrique particulière. Par exemple, le tissu peut être constitué de n'importe quelle combinaison de matériaux et de types, comme un fil conducteur entrelacé avec un fil de matériau conducteur. Les possibilités sont immenses.

Ainsi, par exemple, au moins une des fibres composant le tissu est une fibre comprenant un premier fil en matériau conducteur d'électricité et un second fil en matériau thermoformable déformable. Par exemple, le premier et le second fil sont entrelacés. Plus de deux fils peuvent être utilisés pour former le tissu, par exemple un troisième fil de textile peut être ajouté aux premiers et deuxièmes fils lors de leur combinaison. Le tissu est représenté comme étant tissé, mais il pourrait être relié par tricotage ou d'une autre manière, associé ou simplement disposé à proximité l'un de l'autre.

Il est à noter que tout matériau compatible avec le thermoformage peut être utilisé dans la présente invention, comme les polymères, les polymères chargés, les polymères dopés, les copolymères dont la dureté ou l'élasticité peut être modulée, les résines, éthylène-acétate de vinyle (EVA), polystyrène (PS), polyéthylène (PE), polypropylène (PP), polycarbonate (PC), acrylonitrile butadiène styrène (ABS), polychlorure de vinyle (PVC), polyméthacrylate de méthyle (PMMA), polystyrène choc (SB), Nylon, etc. Les polymères ou résines peuvent être chargés d'EVA pour moduler l'élasticité des fibres ou des fils qui composent le tissu.

L'entrecroisement des premiers et seconds fils pour former un tissu peut, par exemple, être réalisé à l'aide d'une technique de recouvrement. Filix, par exemple, propose de tels fils. Toute autre technique peut également être utilisée. Alternativement, les fils peuvent être entrelacés (manuellement ou à la machine) pour former une ou plusieurs fibres.

La présente invention utilise un tissu configuré pour tirer parti d'un phénomène connu sous le nom d'effet Seebeck. L'effet Seebeck est un effet dans lequel une force électromotrice (EMF) se développe à travers deux points d'un textile électriquement conducteur lorsqu'il y a une différence de température entre eux. La force électromotrice générée donne lieu à une tension et à un courant associé entre les connexions à l'intérieur du textile conducteur. La possibilité de détecter le courant et/ou la tension donne lieu à de nombreuses applications utiles. L'effet Seebeck est dû à la formation de deux types différents de jonction électrique par la combinaison d'un premier et d'un second fil, ces fils ayant un coefficient Seebeck différent.

Comme décrit, les aspects de l'invention utilisent l'effet Seebeck et il sera apprécié qu'un dispositif similaire en tissu souple utilisant l'effet Peltier soit également réalisable en utilisant le tissu souple selon la présente invention. L'effet Seebeck est basé sur la création d'électricité entre un thermocouple ou une jonction lorsque les extrémités sont soumises à une différence de température entre elles. L'effet Peltier est un effet opposé et se produit lorsqu'une différence de température est créée entre les jonctions en appliquant une différence de tension entre les bornes. Une surface chaude en contact avec la jonction froide sera refroidie et une surface froide en contact avec la jonction chaude sera réchauffée. On comprendra que les effets Seebeck et Peltier sont opposés l'un à l'autre, et que l'effet Peltier peut être utilisé pour appliquer la chaleur et le froid plutôt que pour les détecter, mais il fonctionne essentiellement dans le même contexte et en utilisant des matériaux similaires ou identiques.

D'une manière générale, les effets Seebeck et Peltier ont en commun d'être des effets basés sur un effet thermoélectrique et un coefficient associé à l'effet peut être attribué à différents matériaux, ce qui permet d'utiliser l'un ou l'autre dans de nombreux dispositifs et applications thermoélectriques. L'effet thermoélectrique et les coefficients associés peuvent être utilisés dans différents dispositifs thermoélectriques pour différentes fonctions. Par exemple, l'effet Seebeck peut être utilisé dans des dispositifs pour déterminer une différence de température entre différents endroits et/ou jonctions, tels que les jonctions chaudes et froides décrites ici. Dans un autre exemple, l'effet Peltier peut être utilisé dans des dispositifs pour appliquer ou retirer de la chaleur d'une situation ou d'un environnement.

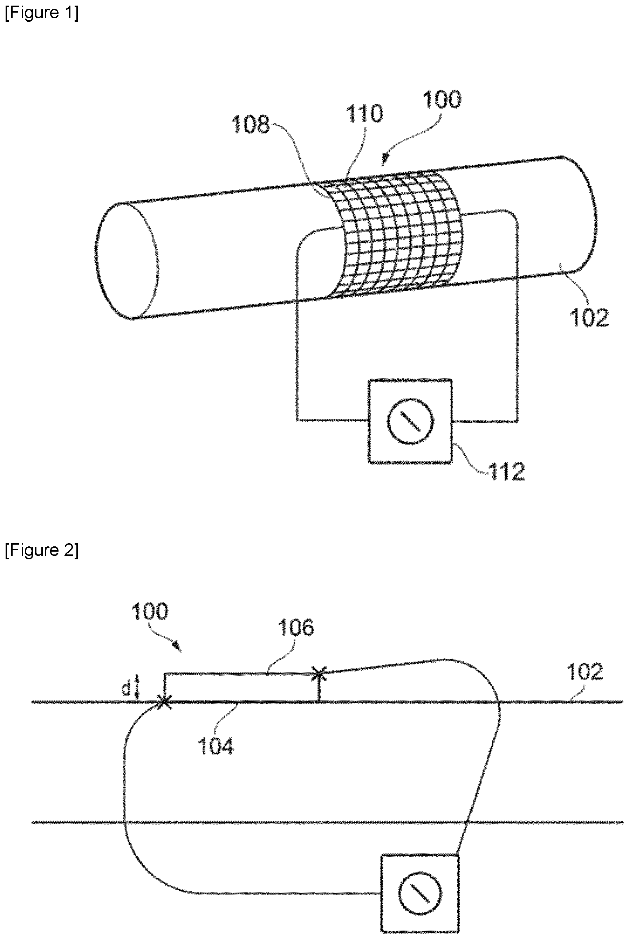

La figure 1 montre un tissu flexible 100 qui, dans ce cas, est fixé à un tuyau de transport de fluide 102 afin d'être utilisé comme capteur pour mesurer un gradient thermique. La figure 2 est une coupe transversale de la figure 1 pour faciliter la compréhension. Le gradient thermique est mesuré entre une surface interne 104 du capteur comparé à une surface externe 106 du tissu flexible 100. Le tissu souple 100 est constitué de fibres 108 et 110 entrelacées comme décrit ci-dessus et plus en détail ci-dessous. Le tissu est connecté à un compteur ou à une alimentation en tension 112.

Le tissu souple 100 comprend des jonctions où les fibres se chevauchent ou sont cousues ensemble. Les fibres ont chacune un coefficient Seebeek différent et les changements de température du tuyau sous-jacent génèrent un courant ou une tension qui peut être mesuré(e) et converti(e) en une différence de température entre les surfaces intérieure et extérieure, comme décrit ci-dessous. Le tissu souple 100 est représenté comme un patch ayant une épaisseur d et une surface plane A. En augmentant la surface ou l'épaisseur, la surface de capture de la chaleur augmente, et donc la quantité d'énergie mesurée augmente également. La taille du tissu souple 100 peut varier en fonction des cas d'utilisation et des situations. Il est à noter que ces types de capteurs flexibles peuvent être ajoutés à des environnements peu ou pas accessibles avant leur déploiement afin de fournir un capteur in situ pour des endroits où la mesure est difficile ou inaccessible avec d'autres types de capteurs.

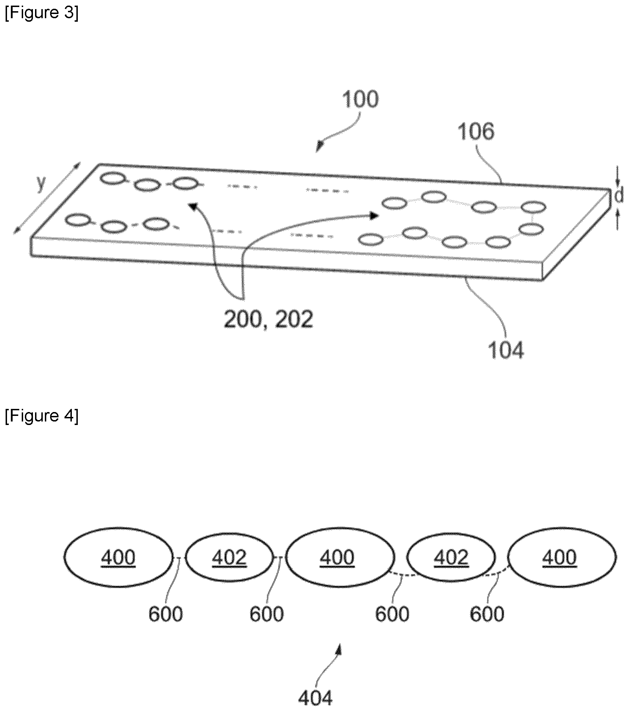

La nature du tissu souple est maintenant décrite plus en détail en référence à la figure 3. Le tissu souple 100 comprend un certain nombre de jonctions 200 et 202 causées par la combinaison des fibres 108 et 110 (non représentées sur la figure 3). Les jonctions sont respectivement une jonction froide 200 et une jonction chaude 202. Le gradient de température se situe entre les surfaces intérieure et extérieure 104 et 106. La tension ou l'énergie produite par l'effet Seebeck passe dans la direction y. L'ensemble est fourni sous forme de moule où les fils ne sont pas directement visibles, car ils sont recouverts d'une gaine ou d'un autre revêtement qui peut être un isolant.

La nature des matériaux utilisés pour former le tissu souple 100 dicte la plage de température du dispositif en tissu souple, qui peut aller de quelques centaines de degrés Celsius à plusieurs centaines de degrés Celsius. Par exemple, un premier matériau peut être le carbone, qui fournit une jonction relativement froide par rapport à un second matériau, l'argent, qui fournit une jonction chaude. De nombreux autres matériaux peuvent être utilisés, y compris, mais sans s'y limiter, pour le premier matériau : carbone, aluminium, scandium, tungstène, nickel, et pour le second matériau : argent, or, fer, cadmium, cuivre, zirconium, sélénium, chrome, lithium.

D'une manière générale le choix des matériaux sera guidé par les écarts entre les coefficients Seebeck des matériaux qui sont négatifs ou positifs par exemple le fer est donné à +11,6 et le Tungstène à -4,4. Le choix résultera d'un compromis entre les coefficients Seebeck et la capacité à utiliser ces matériaux en solution textile.

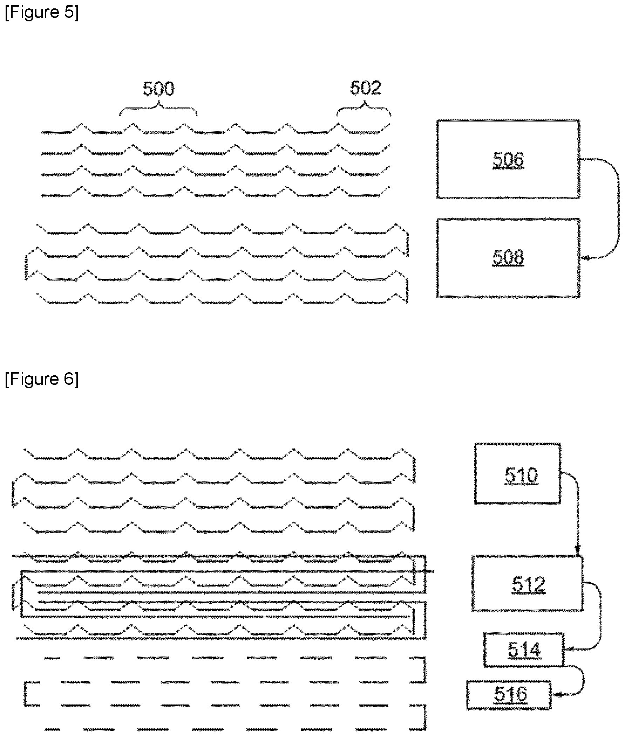

La figure 4 montre comment les noeuds ou jonctions 200 et 202 peuvent être formés en utilisant par exemple une fibre de carbone 400 enduite de thermoplastique et une fibre d'argent 402 enduite de thermoplastique. Les noeuds ou jonctions formés sont chauds pour le carbone et relativement froids pour l'argent. La formation des jonctions peut aboutir à un fil ou à une fibre 404 présentant une alternance de jonctions chaudes et froides. Ce fil peut ensuite être utilisé dans la formation du tissu comme décrit dans les figures 5 et 6.

Comme décrit ailleurs, les aspects de l'invention utilisent l'effet Seebeck et il sera apprécié qu'un tissu flexible similaire 100 utilisant l'effet Peltier soit également réalisable selon la présente invention. L'effet Seebeck est basé sur la création d'électricité entre un thermocouple ou une jonction lorsque les extrémités sont soumises à une différence de température entre elles. L'effet Peltier est un effet inverse et se produit lorsqu'une différence de température est créée entre les jonctions par l'application d'une différence de tension entre les bornes. Une surface chaude en contact avec la jonction froide sera refroidie et une surface froide en contact avec la jonction chaude sera réchauffée. On appréciera que les effets Seebeck et Peltier soient opposés l'un à l'autre, et que l'effet Peltier puisse être utilisé pour appliquer la chaleur et le froid plutôt que pour les détecter, mais qu'il fonctionne essentiellement dans le même contexte et en utilisant des matériaux similaires ou identiques. Un tissu flexible 100 utilisant l'effet Seebeck agit comme un capteur et un tissu flexible 100 utilisant l'effet Peltier agit comme un dispositif de réchauffement ou de refroidissement. Par commodité et pour inclure les deux effets, le dispositif utilisant l'effet Seebeck ou Peltier est généralement appelé dispositif thermique dans le présent document.

Les figures 5 et 6 illustrent la manière dont le tissu souple 100 peut être fabriqué à la machine en cousant ou en combinant les fibres nécessaires à la fabrication de la fibre souple 100 et des dispositifs thermiques associés. Le dispositif est fabriqué à partir d'une combinaison d'un premier matériau 500 et d'un second matériau 502. Le fil de la figure 4 peut être utilisé ou un autre fil ayant des jonctions dans une configuration différente de celle montrée dans la figure 4. La nature exacte du fil dépendra du nombre et de la densité des jonctions prédéterminées. Les étapes de fabrication de la fibre flexible selon la présente invention sont les suivantes.

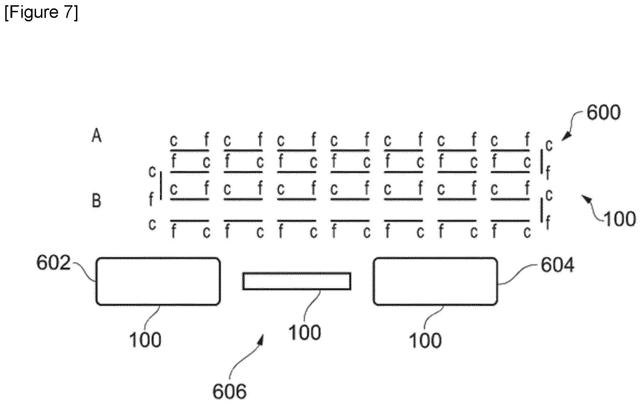

Dans une première étape 506, le premier matériau 500 est cousu dans une forme et une taille prédéterminée pour former un premier ensemble de jonctions. Le matériau comprend un revêtement soluble dans l'eau. À l'étape 508, le second matériau est cousu ou combiné d'une autre manière pour former un second ensemble de jonctions. Le premier matériau peut comprendre un matériau ayant un premier coefficient Seebeck ou Peltier et le second matériau est un matériau ayant un second coefficient Seebeck ou Peltier différent. Les fibres du second matériau peuvent également comprendre un revêtement soluble dans l'eau. Les fibres peuvent être pourvues d'un matériau thermiquement réactif qui s'assouplit pour assembler les différentes couches et former le tissu souple. Dans une étape 510, la structure des couches est chauffée pour fusionner les différentes couches de fibres à l'aide d'un matériau thermoactif tel que les exemples décrits ci-dessus. À l'étape 512, la structure des couches est traitée pour exposer la jonction. Cela peut se faire en coupant l'excès de matériau pour exposer les jonctions ou peut être basé sur une autre méthode d'exposition. À l'étape 514, le matériau soluble dans l'eau est éliminé à l'aide d'un bain d'eau dans lequel le matériau soluble dans l'eau peut se dissoudre. À l'étape 516, on obtient un tissu souple présentant les jonctions chaudes et froides requises. Bien que les étapes ci-dessus soient présentées dans un seul ordre, un ordre différent peut être utilisé dans différentes situations. Par exemple, les jonctions peuvent être exposées avant d'être encapsulées dans un revêtement résistant à l'eau. Le revêtement hydrosoluble peut ne pas être nécessaire ou un matériau dissoluble dans un autre solvant peut être utilisé. D'autres changements et variations seront évidents pour l'homme du métier. Comme le montre la figure 7, le tissu flexible final 100 est produit. Le tissu comprend une pluralité de noeuds ou de points 600 désignés par C et F (respectivement chaud et froid). Ceux-ci sont disposés de telle sorte que la surface supérieure 602 comporte des jonctions chaudes C et la surface inférieure 604 des jonctions froides F. Comme on le voit sur la face 606, les fils peuvent alors être posés de part et d'autre d'un substrat thermiquement isolant, avec une face chaude et une face froide : dans ce cas, la tension générée entre A et B sera négative ou positive (inversée) si les faces sont inversées. En cas de gradient thermique, le système devient un générateur électrique à effet Seebeck, dont la puissance dépend du nombre de jonctions. En appliquant une tension entre A et B, on peut utiliser l'effet Peltier.

Dans les exemples présentés, les jonctions chaudes et froides sont en nombre égal, ce qui n'est pas forcément le cas. En outre, il peut y avoir une séquence différente de jonctions dans une ou plusieurs directions à l'intérieur de la structure en couches du matériau. Il peut y avoir des couches supplémentaires, comme par exemple plusieurs couches isolantes insérées entre plusieurs couches tissées, lorsqu'il y a plus de deux couches actives du premier et du second matériau. La combinaison des jonctions (chaudes et froides) peut avoir n'importe quelle forme ou taille prédéterminée en fonction du cas d'utilisation.

Dans l'exemple présenté, il y a deux couches actives séparées par une couche isolante activable thématiquement, comme le montre la figure 6. Pour certaines applications, il peut y avoir des couches actives supplémentaires et, dans ce cas, des matériaux supplémentaires ayant des coefficients Seebeck ou Peltier différents. La description ci-dessus comprend divers cas d'utilisation, qui ne sont donnés qu'à titre d'exemple, et de nombreuses autres utilisations peuvent être envisagées.

Le tissu pour lequel le connecteur est utilisé peut également varier et comprendre à la fois des matériaux conducteurs et non conducteurs. Le tissu peut être tissé, non tissé, tricoté ou formé d'une autre manière. Si le tissu est conducteur, au moins certains des fils seront fabriqués à partir d'un matériau conducteur d'électricité.

Il sera apprécié qu'il existe de nombreuses variations des caractéristiques décrites ci-dessus qui est incluses dans le champ d'application des revendications annexées.

### Liste de signes de référence

tissu flexible 100
tuyau de transport de fluide 102
surface intérieure 104
surface extérieure 106
fibres 108 et 110
compteur ou alimentation 112
jonction froide 200
jonction chaude 202
fibre de carbone revêtue de thermoplastique 400
fibre d'argent revêtue de thermoplastique 402
fil ou fibre 404
premier matériau 500
deuxième matériau 502
première étape 506
deuxième étape 508
troisième étape 510
quatrième étape 512
cinquième étape 514
sixième étape 516
noeuds ou points 600
surface supérieure 602
surface inférieure 604
côté 606

## Revendications

1. Dispositif en tissu souple destiné à être utilisé dans des applications thermiques, **caractérisé en ce qu'**il comprend un tissu souple (100) constitué d'une combinaison d'un premier ensemble de jonctions (200, 400) et d'un deuxième ensemble de jonctions (202, 402) formés chacun à partir d'un premier et d'un deuxième matériaux respectifs, chacun ayant un premier coefficient thermoélectrique et un deuxième coefficient thermoélectrique connus, le premier ensemble de jonctions (200, 400) étant séparé du deuxième ensemble de jonctions (202, 402) par un troisième matériau et l'un des éléments suivants étant généré sur la base des premier et deuxième coefficients thermoélectriques :
- une réponse électrique entre le premier ensemble de jonctions (200, 400) et le deuxième ensemble de jonctions (202, 402) en fonction d'un gradient de température différent entre eux ; et
- une réponse thermique entre le premier ensemble de jonctions (200, 400) et le deuxième ensemble de jonctions (202, 402) basée sur une différence de gradient électrique entre eux.

2. Dispositif en tissu souple selon la revendication 1, **caractérisé en ce que** le premier coefficient thermoélectrique est le coefficient de Seebeck et **en ce que** ledit dispositif est un capteur pour déterminer un gradient thermique (d) dans un environnement prédéterminé.

3. Dispositif en tissu souple selon la revendication 1, **caractérisé en ce que** le premier coefficient thermoélectrique est le coefficient de Peltier et **en ce que** ledit dispositif est un élément de chauffage ou de refroidissement d'un environnement.

4. Dispositif en tissu souple selon l'une quelconque des revendications précédentes, **caractérisé en ce que** le premier ensemble de jonctions (200, 400) est formé dans une première couche et le deuxième ensemble de jonctions (202, 402) est formé dans une deuxième couche et la première et la deuxième couche sont séparées l'une de l'autre par une couche du troisième matériau.

5. Dispositif en tissu souple selon l'une quelconque des revendications précédentes, **caractérisé en ce que** le premier ensemble de jonctions (200, 400) et le deuxième ensemble de jonctions (202, 402) sont respectivement des jonctions chaudes et froides.

6. Dispositif en tissu souple selon l'une quelconque des revendications précédentes, **caractérisé en ce que** le premier ensemble de jonctions (200, 400) et le deuxième ensemble de jonctions (202, 402) sont formés en cousant des fibres des matériaux respectifs ensemble pour former des points ou des noeuds.

7. Dispositif en tissu souple selon l'une quelconque des revendications précédentes, **caractérisé en ce que** la densité du premier ensemble de jonctions (200, 400) et du deuxième ensemble de jonctions (202, 402) est associée à une précision de fonctionnement du dispositif en cours d'utilisation.

8. Dispositif en tissu souple selon l'une quelconque des revendications précédentes, **caractérisé en ce que** le premier matériau est choisi dans le groupe comprenant : carbone, aluminium, scandium, tungstène, nickel ;
et le second matériau est choisi dans le groupe comprenant : argent, or, fer, cadmium, cuivre, zirconium, sélénium, chrome, lithium.

9. Dispositif en tissu souple selon l'une quelconque des revendications précédentes, **caractérisé en ce que** le troisième matériau est choisi dans le groupe comprenant les polymères, les polymères chargés, les polymères dopés, les copolymères dont la dureté ou l'élasticité peut être modulée, les résines, éthylène-acétate de vinyle (EVA), polystyrène (PS), polyéthylène (PE), polypropylène (PP), polycarbonate (PC), acrylonitrile butadiène styrène (ABS), polychlorure de vinyle (PVC), polyméthacrylate de méthyle (PMMA), polystyrène choc (SB),et Nylon.

10. Procédé de formation d'un dispositif en tissu souple à partir d'un tissu souple (100) selon l'une quelconque des revendications précédentes, ledit procédé étant **caractérisé en ce qu'**il comprend les étapes suivantes :
la formation (506) de premières jonctions dans une couche d'un premier matériau (502) ayant un premier coefficient thermoélectrique ;
la formation (508) des secondes jonctions dans la couche d'un second matériau (504) ayant un second coefficient thermoélectrique ;
la fusion (510) des couches à l'aide d'un matériau thermoactif ; et
l'exposition des jonctions dans les couches pour permettre aux premier et second matériaux de réagir à la chaleur, dans lequel le tissu flexible formé (100) est configuré pour l'un des éléments suivants :
la génération d'une réponse électrique entre les premières jonctions et les secondes jonctions sur la base d'une différence de gradient de température entre elles ; et
la génération d'une réponse thermique entre les premières jonctions et les secondes jonctions sur la base d'une différence de gradient électrique entre elles.

11. Procédé selon la revendication 10, **caractérisé en ce que** les premières et secondes jonctions sont formées en cousant un fil ayant une configuration prédéterminée de premières et secondes jonctions dans le tissu flexible (100).

12. Procédé selon l'une quelconque des revendications 10 et 11, **caractérisé en ce que** le premier et le deuxième matériaux comprennent un revêtement amovible.

13. Procédé selon la revendication 12, **caractérisé en ce que** le revêtement est soluble dans l'eau et la méthode comprend en outre l'élimination (514) du matériau soluble dans l'eau à l'aide d'un bain d'eau dans lequel le matériau soluble dans l'eau peut se dissoudre.

14. Procédé selon la revendication 12, **caractérisé en ce qu'**il comprend en outre une étape d'exposition des jonctions dans les couches pour permettre au premier et au second matériau d'être sensibles à la chaleur, et une étape de découpage du revêtement amovible du premier et du second matériau.
